(19) **Europäisches Patentamt**

**European Patent Office**

**Office européen des brevets**

(11) **EP 1 275 974 B1**

(12) **EUROPÄISCHE PATENTSCHRIFT**

(45) Veröffentlichungstag und Bekanntmachung des Hinweises auf die Patenterteilung:
**18.05.2005 Patentblatt 2005/20**

(51) Int Cl.$^7$: **G01R 33/48**, G01R 33/54

(21) Anmeldenummer: **02014668.4**

(22) Anmeldetag: **03.07.2002**

(54) **Verfahren zur TR-unabhängigen Multi-Slice (TRIM) Bildgebung**

Method for TR-independent multislice imaging (TRIM)

Procédé pour l'imagerie multicouche indépendante de TR (TRIM)

(84) Benannte Vertragsstaaten:
**AT CH DE GB LI**

(30) Priorität: **10.07.2001 DE 10133491**

(43) Veröffentlichungstag der Anmeldung:
**15.01.2003 Patentblatt 2003/03**

(73) Patentinhaber: **Universitätsklinikum Freiburg**
**78106 Freiburg (DE)**

(72) Erfinder: **Fautz, Hans-Peter**
**79106 Freiburg (DE)**

(74) Vertreter: **Kohler Schmid Möbus**
**Patentanwälte**
**Ruppmannstrasse 27**
**70565 Stuttgart (DE)**

(56) Entgegenhaltungen:
**DE-A- 4 137 217**    **US-A- 5 420 509**

- **FAUTZ H-P. ET AL: "TRIM: TR-independent Multi-Slice Imaging" PROCEEDINGS OF THE INTERNATIONAL SOCIETY FOR MAGNETIC RESONANCE IN MEDICINE, TENTH MEETING PROCEEDINGS, 18. Mai 2002 (2002-05-18), XP002282127 HONOLULU, HI, USA**

**Beschreibung**

In der bildgebenden Kernspintomographie werden zwei-dimensionale Scheibenbilder von einem zu untersuchenden Objekt gewonnen. Für die Abbildung eines Volumens werden Sätze von parallelen Scheiben gewonnen, die die Raumrichtung orthogonal zu diesen Scheiben aufspannen.

Für die Aufnahme eines Bildes sind i.A. *m* Teilschritte erforderlich, in denen jeweils *n* komplexe Datenpunkte aufgenommen werden. Die Bildrekonstruktion aus den $m \times n$ Datenpunkten erfolgt je nach Ortscodierung mittels einer zweidimensionalen Fouriertransformation (2DFT) [1] oder durch eine zwei-dimensionale gefilterte Rückprojektion [2-3]. Zwischen zwei Teilschritten wird jeweils das magnetische Feld durch zeitlich veränderliche Magnetfeldgradienten variiert. Bei der 2DFT-Methode beruht die Variation auf dem Schalten von sogenannten Phasenkodiergradienten. In diesem Fall nennt man die Teilschritte deshalb auch Phasenkodierschritte (PK-Schritte). Im Allgemeinen wird eine Scheibe zur Aufnahme mehrerer PK-Schritte mehrfach angeregt. Die Zeit zwischen zwei Anregungen, die sogenannte Wiederholzeit TR liegt in der Größenordnung der NMR Relaxationszeiten und bestimmt den Bildkontrast.

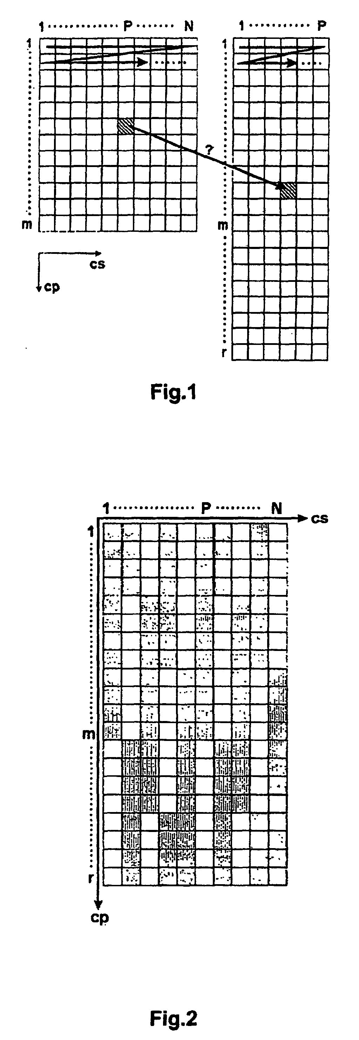

Mit Hilfe von frequenzselektiven (schmalbandigen) HF-Pulsen, die unter einem konstanten Magnetfeldgradienten eingestrahlt werden, können selektiv Scheiben einer gewissen Dicke angeregt werden. Multi-Slice Bildgebung wird eine Klasse von Methoden genannt, die innerhalb einer Wiederholzeit TR nacheinander mehrere Scheiben anregen und auslesen [4]. Bei jeder Wiederholung wird ein anderer Phasenkodierschritt von jeder dieser Scheiben aufgenommen (siehe Fig.1, linke Bildhälfte). Die Scheiben, die in einer Wiederholungsperiode angeregt werden, definieren ein Volumen. Dieses bleibt bis zur vollständigen Aufnahme aller Scheiben des Volumens identisch und wird in jeder Wiederholungsperiode in der gleichen Scheibenabfolge angeregt.

Der zeitliche Abstand zwischen zwei aufeinanderfolgenden Anregungen der gleichen Scheibe ist für alle Scheiben gleich der Wiederholzeit TR. Alle Scheiben haben damit identische Bildeigenschaften. Das Volumen wird in m Wiederholungen in der nahezu gleichen Aufnahmezeit aufgenommen, die für die Aufnahme einer Scheibe mit äquivalenten Bildeigenschaften benötigt wird.

Eine Modifikation der konventionellen Multi-Slice Methode ist aus eingangs zitierten DE 41 37 217 A1 bekannt. Die Scheibenpositionen zweier prinzipiell einer Scheibe zugeordneten, nacheinander aufgenommener PK-Schritte unterscheiden sich um ein im Vergleich zur Scheibendicke kleines Inkrement. Durch die räumliche Verteilung der PK-Schritte können ohne zusätzliche Datenaufnahme mittels entsprechender Kombinationen der PK-Schritte zusätzliche, sich überlappende Scheiben rekonstruiert werden [5,6].

Dies ist eine Methode, um Lücken zwischen den rekonstruierten Scheiben zu vermeiden. In der konventionellen Methode entstehen dadurch Lücken, dass die innerhalb einer Wiederholzeit verwendeten Pulse wegen ihrer gegenseitigen Beeinflussung aus den Flanken der Pulse einen bestimmten Abstand zueinander haben müssen [7,8]. Um eine lückenlose oder gar überlappende Abdeckung eines Volumens zu erhalten, müssen in sequentiellen Messungen zwei oder mehrere Volumina aufgenommen werden, die gegeneinander verschoben sind.

Die Anzahl der Scheiben, die in einer konventionellen Multi-Slice Messung aufgenommen werden können, ist bei gegebenem Kontrast durch die Wiederholzeit TR begrenzt. Reicht diese Anzahl nicht, um ein gewünschtes Volumen abzudecken, müssen weitere Scheiben sequentiell in nachfolgenden Messungen aufgenommen werden. Dies erfordert ein ganzzahliges Vielfaches an Messzeit. Weitere Nachteile für die Untersuchung können entstehen, wenn

Ebenso müssen größere Volumina, die über die Homogenität der Spulensensitivität oder des B-Feldes hinausgehen, sequentiell aufgenommen werden. Zwischen den Aufnahmen wird das Messobjekt verschoben. Eine kontinuierliche Aufnahme z.B. unter kontinuierlichem Vorschub des Messobjektes ist mit einer Multi-Slice Technik derzeit nicht möglich.

Aufgabe der vorliegenden Erfindung ist es demgegenüber, ein Verfahren der eingangs beschriebenen Art so zu verbessern, dass die oben diskutierten Nachteile vermieden werden können. Insbesondere soll die Erfindung eine neue Multi-Slice Methode vorstellen mit dem Ziel, die Anzahl der in einer Messung aufgenommenen Scheiben unabhängig von der den Bildkontrast bestimmenden Wiederholzeit zu machen.

Erfindungsgemäß wird diese Aufgabe auf wirkungsvolle Art und Weise dadurch gelöst, dass die Aufnahme in r Wiederholzyklen, mit r>m, durchgeführt wird, und dass während jedem dieser Wiederholzyklen Daten aus P Schichten, mit P<N, akquiriert werden, wobei N kein ganzzahliges Vielfaches von P ist,

- wobei zur Aufnahme des vollständigen Datensatzes von m*N Aufnahmeschritten die Anzahl der Wiederholzyklen r = m*N/P ist, wobei eventuelle, durch Nichtteilbarkeit von m*N durch P übrigbleibende Schritte angehängt oder ignoriert werden,

- wobei die Ortskodierung während jedes Wiederholungszyklus von Schicht zu Schicht unterschiedlich sein kann, aber nicht notwendig muss, solange nach r Wiederholungen für jede Schicht alle m Ortskodierungsschritte aufgenommen wurden, bis auf die zuvorgenannten etwaigen übrigbleibenden Schritte,

- und wobei auch die Position der P Schichten innerhalb des durch die Gesamtzahl N der aufzunehmenden Schichten definierten Untersuchungsvolumens variieren kann, aber nicht notwendig muss, solange nach Beendigung der Aufnahme vollständige Daten zur Rekonstruktion von N Schichten innerhalb des Untersuchungsvolumens vorliegen.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung. Die Erfindung ist in der Zeichnung dargestellt und wird anhand von Ausführungsbeispielen näher erläutert.

## 2. Methode

Die neue Methode wird im Folgenden TR independent Multi-Slice (TRIM) genannt. Eine spezielle Anwendung der Methode ist die Aufnahme von multiplen Scheiben unter kontinuierlichem Vorschub des Messobjektes.

Unter Verwendung der positionsvariablen Phasenkodierung kann der Abstand der in einer Wiederholzeit verwendeten Pulse von dem Abstand der aufgenommenen Scheiben unabhängig gemacht werden. Damit bietet die Methode eine neue Möglichkeit, innerhalb einer Messung beliebig nah beieinander liegende oder überlappende Scheiben aufzunehmen.

Die Erfindung ist auf alle üblichen Multi-Slice Methoden anwendbar.

Ist die Anzahl der aufzunehmenden Scheiben N gegeben, müssen insgesamt ($N*m$) PK-Schritte aufgenommen werden. Bei einer für die Aufnahme eines PK-Schrittes benötigten Zeit TA beträgt die Gesamtaufnahmezeit $T_{ges} = N*m*TA$. In der konventionellen Multi-Slice Methode werden in einer Wiederholzeit jeweils alle N Scheiben nacheinander angeregt. Das Kontrast-bestimmende Intervall TR ist $TR = N*TA$. In der neuen TRIM Methode wird das Kontrast-bestimmende Intervall von $TR = N*TA$ auf $TR = P*TA$ reduziert mit einem $P < N$. Um alle PK-Schritte aufzunehmen, muss durch die Reduktion der Anregungen pro Wiederholung die Anzahl der Wiederholungen von m auf r erhöht werden, so dass $r*P = N*m$. Die Gesamtaufnahmezeit bleibt konstant. Die Aufgabe lässt sich wie folgt definieren: Eine ($P\times r$)-Matrix, in die die PK-Schritte einer Wiederholung zeilenweise eingetragen werden, ist so zu gestalten, dass alle Schichten während der gesamten Aufnahme ein konstantes $TR = P*TA$ sehen (Fig.1).

Dieses Problem lässt sich mit Hilfe der Kombinatorik lösen und zwar dadurch, dass die Gesamtzahl der ($N*m$) notwendigen Aufnahmeschritte in eine Matrix der Größe ($N \times r$) eingefüllt wird. In jede Zeile werden P und in jede Spalte m Schritte eingefüllt (Fig.2). Wenn $P > N/2$ und damit $r < 2m$, ist die Aufgabe dadurch lösbar, dass statt der Aufnahmeschritte eine entsprechende Anzahl von Lücken eingefügt werden. Die Anzahl der Lücken beträgt in Zeilenrichtung ($N - P$) und in Spaltenrichtung ($r - m$).

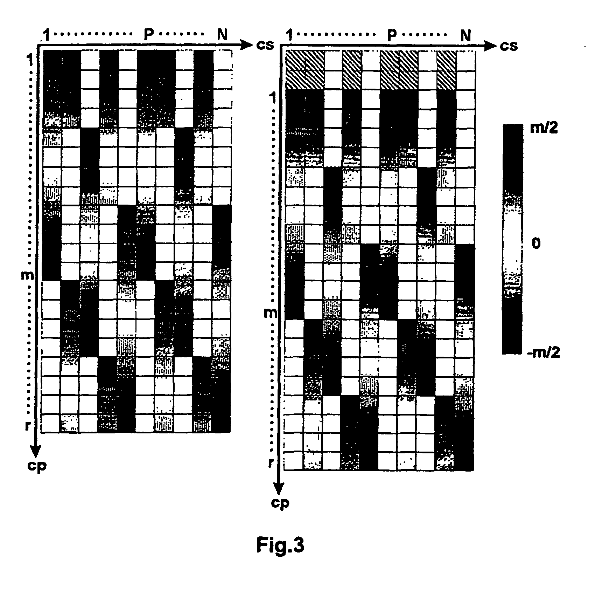

Cp und cs aus Fig.2 sind Zähler. Die Zuordnung zu den entsprechenden k-Raumkoordinaten (für cp) und geometrischen Positionen der Schichten (für cs) kann beliebig erfolgen, solange die Bedingung erfüllt ist, dass für alle Schichten alle PK-Schritte aufgenommen werden. Jedem cs wird in freier räumlicher Zuordnung eine bestimmte Schicht zugeordnet (Fig.3). Die Zuordnung des jeweiligen PK-Schrittes zur Schicht cs während der Aufnahme cp ist frei. Die Phasenkodierung der im Schritt cp aufgenommen Aufnahmeschritte kann von Schicht zu Schicht unterschiedlich sein.

Für ($N = P$) geht die TRIM Methode in die konventionelle Multi-Slice Methode über. Ist N ein Vielfaches von P, lässt sich die TRIM Methode als Spezialfall auf eine sequentielle konventionelle Aufnahme zurückführen.

Die Gesamtanzahl aller PK-Schritte ($N*m$) muss nicht notwendigerweise ein Vielfaches von P sein. Die Methode lässt sich für jedes beliebige P ($1 < P < N$) anwenden. I.A. ist dann eine unvollständige letzte Zeile an die ($P\times r$)-Matrix aus Fig.1 angehängt.

*2. 1. Abbildungseigenschaften bezüglich der durch die Design-Matrix bestimmten Wiederholzeit*

Die Belegung der Designmatrix bringt die Aufnahme aller PK-Schritte nach Scheibenzugehörigkeit geordnet in ein zeitliches Raster. Die Zeit zwischen zwei Anregungen der gleichen Scheibe bestimmen die wesentlichen Bildeigenschaften. Eine exakte Erfüllung der Bedingung $TR = P*TA$ ist nicht für alle Aufnahmeschritte möglich. Durch die Lücken in Spaltenrichtung entsteht mindestens ein Intervall, für welches eine bestimmte Schicht ein längeres TR erfährt. Die Zahl dieser längeren TR-Intervalle lässt sich dadurch minimieren, dass die Lücken in cp-Richtung möglichst zusammenhängend gewählt werden.

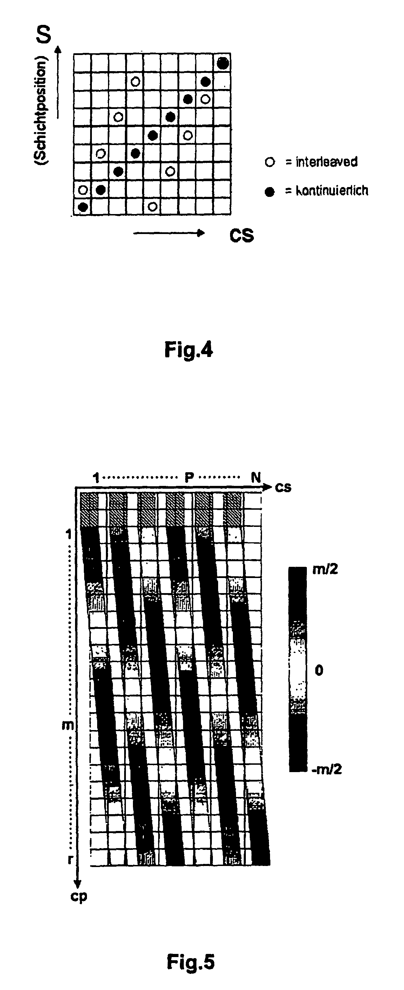

Zur Vermeidung von Artefakten werden die gleichen Methoden benutzt, wie sie auch für die konventionelle Multi-Slice Methode für die ersten Wiederholungen eingesetzt werden. Die PK-Trajektorie jeder Scheibe wird so angepasst, dass Echos nach einem längeren TR-Intervall jeweils für die äußeren k-Raum Bereiche kodiert werden. Aufgrund der Eigenschaften der Fourierabbildung werden so Artefakte im Bild minimiert (Fig.5; links). Eine andere Möglichkeit zur Artefaktreduktion bietet die Verwendung von sogenannten Dummyechos. Das sind Signale, die erzeugt aber nicht für die Bildrekonstruktion verwendet werden. Durch die Magnetisierungspräparation der Dummy-Wiederholungen in Fig.5 (rechts) ist das Signalverhalten der aufgenommenen Echos dem der konventionellen Methode nahezu identisch.

Aus dieser kombinierten Darstellung der Designmatrix von Belegung und PK-Trajektorie können resultierende Bildeigenschaften eines TRIM-Experimentes sehr gut abgelesen werden.

*2.2. Erweiterung des Verfahrens auf kontinuierliche Abtastung*

Im Allgemeinen sind die in einer TRIM-Wiederholzeit verwendeten Pulse nicht äquidistant entlang der Scheibenrichtung verteilt (Fig.2). Außerdem differieren die Abstände zwischen den Pulsen für verschiedene Wiederholungen. Durch die unterschiedliche Beeinflussung aus den Flanken der nicht äquidistanten Pulse können einzelne PK-Schritte verschiedene Signalintensitäten haben als andere [8]. Dies kann zum einen zu Artefakten führen, wenn die Signalschwankungen groß genug sind. Zum andern haben einzelne Scheiben insgesamt eine etwas höhere Bildintensität als andere Scheiben aus dem Scheibensatz.

Dies lässt sich dadurch vermeiden, dass die Schichtposition - wie bei RAMP [5,6] - kontinuierlich verändert wird. Die PK-Schritte, die einer Scheibe zugeordnet sind, werden jeweils um die Hälfte des Abstandes zur nächsten Scheibe um ihre zentrale Scheibenposition herum variiert. Wie Fig.5 zeigt, können damit die (N-P) Lücken in jeder Zeile benutzt werden, um die P Pulse in jeder Wiederholung äquidistant über das gesamte Messvolumen in Scheibenrichtung zu verteilen. Die positionsvariable Phasenkodierung erlaubt somit zwar die Verwendung von äquidistanten Pulsen, allerdings verändert sich auch das Schichtprofil durch diese Art der Phasenkodierung [4,9,10].

## 3. Anwendungen

*3.1. Unabhängige Wahl von Scheibenzahl und Wiederholzeit TR*

Eine Designmatrix wie in Fig.3 lässt sich für eine beliebige Wahl von P und N mit folgenden Eigenschaften konstruieren. Die Löcher werden zusammenhängend auf eine Spalte verteilt und über die Spalten hinweg stetig angeschlossen. Für jede Scheibe zerfällt die PK-Trajektorie in eine Trajektorie oder maximal zwei Teiltrajektorien mit jeweils konstanter Wiederholzeit $TR_{TRIM}$. Diese werden jeweils linear von beiden Enden der k-Raum Matrix zur Mitte hin kodiert. Für übliche Wiederholzeiten von mehr als 50ms wird das Steady-State Signal nach wenigen Echos erreicht. Damit haben TRIM Bilder den gleichen Bildkontrast wie herkömmliche Bilder, die durch die Wiederholzeit $TR_{TRIM}$ charakterisiert sind. Die Wiederholzeit $TR_{TRIM}$ ist unabhängig von der Anzahl der aufgenommen Scheiben N und lediglich durch den freien Parameter P bestimmt. Verglichen mit einer konventionellen N-Scheiben Messung kann die Wiederholzeit, die den Bildkontrast bestimmt, um einen Faktor P/N reduziert werden:

$$TR_{TRIM} = \frac{P}{N} * TR_{konv}$$

Durch die unabhängige Wahl von Scheibenzahl und TR kann die Anzahl der in einer Messung aufgenommenen Scheiben mit nur einer Sequenz optimal an ein abzudeckendes Volumen, z.B. die Ausdehnung eines Organs angepasst werden. Eine limitierte Gesamtaufnahmezeit, z.B. eine Atemstillstandsperiode kann optimal ausgenutzt werden, um unabhängig vom Bildkontrast die größt mögliche Zahl von Scheiben aufzunehmen. Damit können z.B. auch Aufnahmen vor und nach Kontrastmittelgabe bei gleichbleibender Scheibenzahl mit unterschiedlicher Wiederholzeit aufgenommen werden.

*3.2. Multiecho-Sequenzen*

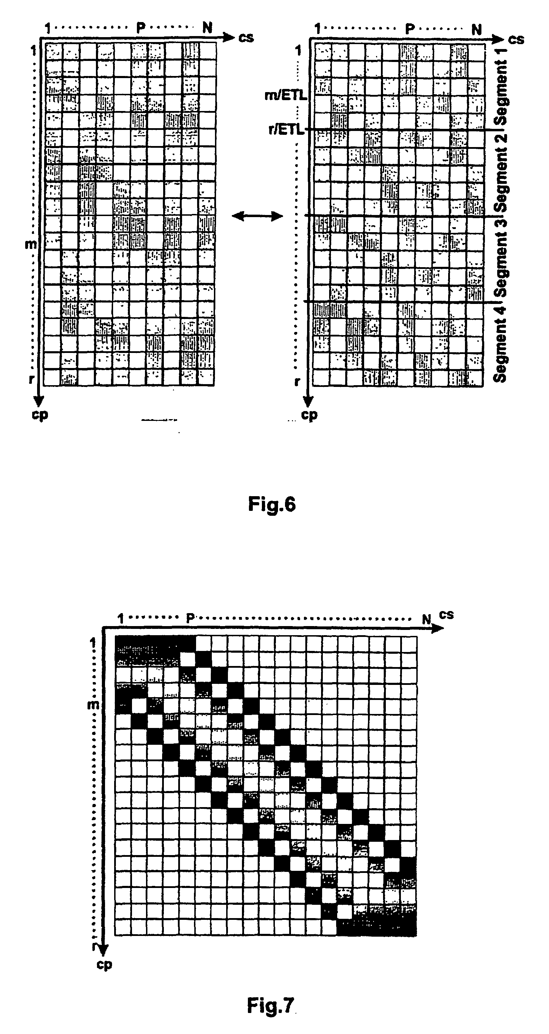

In Multiechosequenzen werden nach nur einer Anregung mehrere Echos erzeugt, um die Anzahl der notwendigen Anregungen zu reduzieren oder in einer Messung mehrere Bilder mit unterschiedlichen Kontrasten zu erzeugen [11-13]. Die Anzahl der pro Anregung aufgenommenen PK-Schritte heißt Echozuglänge (ETL). Die Anzahl der pro Scheibe aufgenommenen PK-Schritte ist ein ganzzahliges Vielfaches der Echozuglänge $m/ETL = n$. Eine Verallgemeinerung der TRIM Methode auf Multiecho-Sequenzen ist besonders einfach, wenn die Anzahl der Lücken in der Designmatrix pro Spalte $(r-m)$ ebenfalls ein ganzzahliges Vielfaches der Echozuglänge ist $(r - m)/ETL = l$. Dann ist auch die Anzahl der Wiederholungen r ein ganzzahliges Vielfaches der Echozuglänge $r/ETL = n + l$. Die gesamte Designmatrix lässt sich in ETL identische Segmente einteilen. Das Designen der Matrix ist auf das Designen eines Segmentes mit $(n + l)$ Wiederholungen zurückgeführt. Die gesamte Matrix wird durch Kopieren dieses Segmentes in cp-Richtung gewonnen (Fig.6). Die verschiedenen Segmente entsprechen den verschiedenen Echosignalen innerhalb eines Echozuges. Die Zuordnung von cp zu den k-Raumkoordinaten ist unabhängig von den Segmenten. Die Zuordnung von cs zu den geometrischen Scheibenpositionen ist für die ETL Segmente identisch.

Multiechosequenzen sind nicht nur aufgrund der minimalen Echoabstände zeiteffizienter als Einzelecho- Sequenzen, sondern besonders geeignet bei der Verwendung von Fett- und anderen Sättigungstechniken. Bei T1-gewichteten Multiecho-Sequenzen ist jedoch die Anzahl der innerhalb eines TR möglichen Scheibenzahl inhärent stark beschränkt. TRIM bietet die Möglichkeit einer flexiblen Scheibenwahl auch mit Multiechosequenzen.

*3.3. Aufnahme überlappender Scheiben*

Die in Fig.5 gezeigte Methode ist nicht nur für die Verwendung von äquidistanten Pulsen in der TRIM Bildgebung geeignet, sondern ebenfalls, um beliebig überlappende Scheiben mit Hilfe eines Multi-Slice Verfahrens aufzunehmen. Die einer Scheibe zugeordneten PK-Schritte, die in aufeinanderfolgenden Wiederholungen aufgenommen werden, unterscheiden sich jeweils um ein Inkrement $\delta z = \Delta z/m$ . Dabei ist □z der Scheibenabstand und m die Anzahl der PK-Schritte pro Scheibe. Wie aus Fig.5 zu entnehmen ist, ist damit der Abstand □□ zwischen den innerhalb einer TRIM Wiederholung verwendeten Pulse um einen Faktor $N/P$ größer als der Scheibenabstand □z.

$$\Delta z = m^*\delta z = \frac{P^*r}{N}^*\delta z = \frac{P}{N}^*\Delta\zeta$$

Bei gegebenem Abstand der (nicht überlappenden) Pulse kann somit der Scheibenabstand beliebig verkleinert werden, indem die Anzahl der gemessenen Scheiben vergrößert wird. Die Scheiben werden dabei mehr und mehr überlappen, ihren Bildkontrast jedoch, der durch $TR_{TRIM}$ und damit durch P bestimmt ist, beibehalten.

*3.4. Kontinuierliche "Ganzkörper-" Multi-Slice Bildgebung*

Für bestimmte Anwendungen wie die Darstellung der Extremitäten oder des Knochenskelettes ist das abzudeckende Volumen ein Vielfaches des Messfensters, das durch die Homogenität des Magnetfeldes und der Spulensensitivität beschränkt ist. Anstatt das Gesamtvolumen sequentiell mit einzelnen Messfenstern abzudecken, ist es auch denkbar, das Gesamtvolumen ähnlich wie beim Spiral-CT kontinuierlich über das Messfenster zu schieben. Dabei ist es wünschenswert, zu jedem Zeitpunkt das Messfenster durch eine Multi-Slice Technik zur Datenakquisition nutzen zu können. Das Problem lässt sich auf die ursprüngliche TRIM- Fragestellung zurückführen. In jeder Wiederholungsperiode werden P PK-Schritte aus einem Subvolumen aufgenommen, das sich über einen Teil des Gesamtvolumens von N Scheiben erstreckt und sich nur allmählich verschiebt.

Dies führt auf eine Designmatrix in der Art, wie sie in Fig.7 gezeigt ist. Eine Segmentierung der m PK-Schritte pro Scheibe in P Segmente bietet sich an, wenn in jeder Wiederholzeit jeweils P Scheiben angeregt werden. Zur vollständigen Aufnahme aller Scheiben werden über ein Segment hinweg die in einer Wiederholzeit angeregten Scheiben um jeweils eine Scheibenposition verschoben.

Diese Vorschubsgeschwindigkeit von P Scheiben in m PK-Schritten ist maximal. Langsamere Vorschübe führen zu einer Überakquisition von Daten. Die zusätzlich aufgenommenen Daten können zu Mittelungen oder zur Akquisition von Zwischenscheiben verwendet werden. Je nach Implementierung kann zu Lasten der Vorschubsgeschwindigkeit zwischen einer erhöhten Scheibenauflösung oder einem erhöhten Signal zu Rausch-Verhältnis gewählt werden.

Unter einem kontinuierlichen Vorschub des Messobjektes erhält man eine positionsvariable Phasenkodierung, wenn die Scheibenanregungsfrequenzen innerhalb eines Segmentes konstant sind. Werden diese Frequenzen innerhalb eines Segmentes über einen Scheibenabstand mitgeführt, erhält man eine konventionelle positionskonstante Phasenkodierung.

**Erläuterungen zu den Abbildungen**

Fig.1: ($N \times m$)- und ($P \times r$)-Matrix mit jeweils N*m Einträgen für die PK-Schritte eines Multi-Slice Experimentes mit N Scheiben. Die innerhalb einer Wiederholung aufgenommenen PK-Schritte werden zeilenweise eingetragen. Konventionell (links) entspricht jeder Spalte eine Scheibenposition und jeder Zeile dem Wert eines verwendeten Phasenkodiergradienten. Die Phasenkodierschritte sind durch die Zeilen- und Spaltenindizee eindeutig gekennzeichnet. Die TRIM Methode bildet die PK-Schritte auf eine ($P \times r$)-Matrix ab, wenn P die Anzahl der Scheiben ist, die in einer Wiederholung angeregt werden (rechts).

Fig.2: Belegung einer Designmatrix zur Aufnahme aller Phasenkodierschritte für N Scheiben (graue Kästchen) in einer Messung mit P Anregungen pro Wiederholung und r Wiederholungen. Die Matrix wird zeilenweise abgearbeitet, wobei die weißen Kästchen übersprungen werden. Sie gibt das zeitliche Raster zur Aufnahme der PK-Schritte an.

Fig.3: Das zeitliches Aufnahme-Muster aus Fig.2 mit der Darstellung der PK-Trajektorie für jede Scheibe durch eine Graukodierung. Die PK-Trajektorie für jede Scheibe ist so gewählt, dass Bildartefakte aufgrund unterschiedlicher Wiederholzeiten minimiert werden. Das Einfügen von Dummy Echos (schraffierte Kästchen) ist eine weitere Methode zur Artefaktreduktion (rechts).

Fig.4: Look-Up-Table für die Zuordnung des Scheibenzählers "cs" zu geometrischen Scheibenpositionen.

Fig.5: TRIM-Anregungsschema unter Verwendung von positionavariabler (ramped) Phasenkodierung. Die einer Scheibe zugeordneten Phasenkodierer variieren um einen halben Scheibenabstand um ihre zentrale Position herum.

Fig.6: Ist die Anzahl der Lücken pro Spalte ein Vielfaches der Echozuglänge ETL, kann die Designmatrix (links) in cp-Richtung in ETL identische Segmente eingeteilt werden (rechts). Es reicht dann ein Segment zu designen, die gesamte Matrix ergibt sich durch Kopieren dieses Segmentes in Phasenkodierrichtung. Die PK-Trajektorien der Scheiben ist unabhängig von den Segmenten.

Fig.7: Darstellung eines Multi-Slice Experimentes mit stufenweisem Vorschub des Messfensters mittels der Designmatrix.

**Literaturzitate:**

[1]    Dössel, Bildgebende Verfahren in der Medizin, Springer,Kap.13.5, S.315 ff, 2000

[2]    Dössel, Bildgebende Verfahren in der Medizin, Springer, Kap.13.5, S.319 ff, 2000

[3]    Scheffler K., et al., *Magn. Reson. Med.,* 40, 474-480, 1998

[4]    Vlaardingerbroek, den Boer, Magnetic Resonance Imaging, Springer, 80f, 1999

[5]    Hennig J., *Journ. of Magn. Reson. Imag.*, 3, 425-432, 1993

[6]    Hennig J., *Patent DE 41 37 217*, 1993

[7]    Bradley W.G., et al., *AJNR,* 8(6), 1057-1062,1987

[8]    Kucharczyk W., et al., *AJNR,* 9(3), 443-451,1988

[9]    Fautz H.-P., et al., *Proc. ISMRM (2000),* 1725, 2000

[10]   Fautz H.-P., et al., *Proc. ISMRM (2001),* 233, 2001

[11]   Mansfield P., et al., *J.Phys.C:Solid State Phys., Vol. 10,* 55-58, 1977

[12]   Hennig J., et al., *Magn. Reson. Med.,* 27, 823-833, 1986

[13]   Feinberg D.A., et al., *Radiology,* 181(2), 597-602,1991

**Patentansprüche**

1.    Bildgebendes Mehrschicht-Verfahren der Magnetresonanz (=NMR) zur Aufnahme von N Schichten, mit N>1, aus einem Untersuchungsvolumen in einem Messobjekt, bei welchem zur vollständigen Bildrekonstruktion eine Aufnahme in m Einzelschritten, mit m>1, durchgeführt wird, wobei die Aufnahme jedes Aufnahmeschrittes jeder Schicht in einer Zeit TA erfolgt,

       **dadurch gekennzeichnet,**
**dass** die Aufnahme in r Wiederholzyklen, mit r>m, durchgeführt wird, und dass während jedem dieser Wiederholzyklen Daten aus P Schichten, mit P<N, akquiriert werden, wobei N kein ganzzahliges Vielfaches von P ist,

-   wobei zur Aufnahme des vollständigen Datensatzes von m*N Aufnahmeschritten die Anzahl der Wiederholzyklen r = m*N/P ist, wobei eventuelle, durch Nichtteilbarkeit von m*N durch P übrigbleibende Schritte angehängt oder ignoriert werden,

-   wobei die Ortskodierung während jedes Wiederholungszyklus von Schicht zu Schicht unterschiedlich sein kann, solange nach r Wiederholungen für jede Schicht alle m Ortskodierungsschritte aufgenommen wurden, bis auf die zuvorgenannten etwaigen übrigbleibenden Schritte,

-   und wobei auch die Position der P Schichten innerhalb des durch die Gesamtzahl N der aufzunehmenden Schichten definierten Untersuchungsvolumens variieren kann, solange nach Beendigung der Aufnahme vollständige Daten zur Rekonstruktion von N Schichten innerhalb des Untersuchungsvolumens vorliegen.

2.    Verfahren nach Anspruch 1, **dadurch gekennzeichnet, dass** eine Gradientenechosequenz angewendet wird, welche entweder als spoiled-FLASH, refocused FLASH, reversed FLASH oder trueFISP ausgebildet ist.

3.    Verfahren nach Anspruch 1, **dadurch gekennzeichnet, dass** Spin-Echo Sequenzen angewendet werden.

4.    Verfahren nach Anspruch 1, **dadurch gekennzeichnet, dass** RARE(TSE)-Sequenzen angewendet werden, so dass in jedem Einzelschritt mehrere unterschiedlich ortskodierte Daten aufgenommen werden.

5.    Verfahren nach einem der vorhergehenden Ansprüche, **dadurch gekennzeichnet, dass** die Abfolge der Wiederholungen so erfolgt, dass für jede Schicht eine möglichst konstante Wiederholzeit P*TA erreicht wird.

6.    Verfahren nach Anspruch 5, **dadurch gekennzeichnet, dass** die Aufnahme in jeder Schicht in zusammenhängenden konsekutiven Wiederholungen erfolgt.

7.    Verfahren nach einem der vorhergehenden Ansprüche, **dadurch gekennzeichnet, dass** die Schichtpositionen der P Schichten von einer Wiederholung zur nächsten kontinuierlich verändert werden, so dass sich nach der Aufnahme mindestens N Schichten innerhalb des Untersuchungsvolumens rekonstruieren lassen.

8.    Verfahren nach einem der vorhergehenden Ansprüche, **dadurch gekennzeichnet, dass** eine Ortskodierung nach dem zwei- oder mehrdimensionalen Fourier Trarisform-Verfahren angewendet wird.

9.    Verfahren nach einem der Ansprüche 1 bis 7, **dadurch gekennzeichnet, dass** eine Ortskodierung nach dem Verfahren der gefilterten Rückprojektion angewendet wird.

**Claims**

1. Imaging multi-slice nuclear magnetic resonance (NMR) method for recording N slices with N>1 from a volume under investigation in a measuring object, wherein for complete image reconstruction, recording in m individual steps with m>1 is carried out, wherein the recording of each recording step of each slice is carried out within a time period TA, **characterized in that** the recording is carried out in r repetition cycles with r>m and during each of these repetition cycles, data from p slices with P<N is acquired,

   - wherein for recording the complete data set of m*N recording steps, the number of repetition cycles is r=m*N/P, wherein possible steps which remain due to the non-divisibility of m*N by P are attached or ignored,

   - wherein the spatial encoding during each repetition cycle can vary from slice to slice as long as all m spatial encoding steps are recorded for each slice after r repetitions, except for the above-mentioned possible remaining steps.

   - and wherein also the position of the P slices can vary within the investigation volume defined by the total number N of slices to be recorded as long as the data for reconstruction of N slices within the investigation volume is complete after termination of the recording.

2. Method according to claim 1, **characterized in that** a gradient echo sequence is applied which is formed either as spoiled FLASH, refocused FLASH, reversed FLASH or trueFISP.

3. Method according to claim 1, **characterized in that** spin echo sequences are applied.

4. Method according to claim 1, **characterized in that** RARE(TSE) sequences are applied such that data with different spatial encoding is recorded in each individual step.

5. Method according to any one of the preceding claims, **characterized in that** the sequence of repetitions is carried out such that a repetition time P*TA which is as constant as possible is obtained for each slice.

6. Method according to claim 5, **characterized in that** the recording is carried out in each slice in coherent consecutive repetitions.

7. Method according to any one of the preceding claims, **characterized in that** the slice positions of the P slices are continuously changed from one repetition to the next such that after recording, at least N slices can be reconstructed within the volume under investigation.

8. Method according to any one of the preceding claims, **characterized in that** spatial encoding is applied according to the two-or more-dimensional Fourier transform method.

9. Method according to any one of the claims 1 through 7, **characterized in that** spatial encoding is applied according to the method of filtered reverse projection.

**Revendications**

1. Procédé pour l'imagerie multicouche de la résonance magnétique (=NMMR) pour l'enregistrement de N couches, avec N>1, à partir d'un volume d'examen dans un objet de mesure, selon lequel pour la reconstruction d'images complète un enregistrement en m étapes individuelles, avec m>1, est effectué, l'enregistrement de chaque étape d'enregistrement de chaque couche s'effectuant dans un temps TA,
   **caractérisé en ce que** l'enregistrement est effectué en r cycles de répétition, avec r>m, et **en ce que** pendant chacun de ces cycles de répétition des données sont acquises à partir de P couches, avec P<N, N n'étant pas un multiple entier de P,

   - pour enregistrer le jeu complet de données de n*N étapes d'enregistrement le nombre de cycles de répétition étant r = m*N/P, des étapes éventuelles restantes en raison de la non divisibilité de m*N par P étant ajoutées ou ignorées,
   - le codage géographique pendant chaque cycle de répétition pouvant être différent d'une couche à l'autre, tant qu'après r répétitions pour chaque couche toutes les m étapes de codage géographique ont été enregistrées, à l'exception des étapes éventuelles restantes citées plus haut,
   - et la position des P couches pouvant également varier à l'intérieur du volume d'examen défini par le nombre total N des couches à enregistrer, tant que l'on est en présence, après l'enregistrement, de données complètes pour la reconstruction de N couches à l'intérieur du volume d'examen.

2. Procédé selon la revendication 1, caractérisé en que l'on utilise une séquence d'écho de gradient qui présente la forme d'un spoiled FLASH, d'un refocused FLASH, d'un reversed FLASH ou d'un true-FISP.

3.  Procédé selon la revendication 1, **caractérisé en ce que** l'on utilise des séquences Spin-Echo.

4.  Procédé selon la revendication 1, **caractérisé en ce que** l'on utilise des séquences RARE(TSE) de telle sorte que l'on enregistre à chaque étape individuelle plusieurs données présentant des codages géographiques différents.

5.  Procédé selon l'une quelconque des revendications précédentes, **caractérisé en ce que** l'ordre des répétitions s'effectue de manière à pouvoir obtenir un temps de répétition P*TA le plus constant possible pour chaque couche.

6.  Procédé selon la revendication 5, **caractérisé en ce que** l'enregistrement s'effectue dans chaque couche par des répétitions consécutives cohérentes.

7.  Procédé selon l'une quelconque des revendications précédentes, **caractérisé en ce que** les positions de couche des P couches varient continuellement d'une répétition à l'autre, de telle sorte qu'après l'enregistrement au moins N couches à l'intérieur du volume d'examen sont reconstruites.

8.  Procédé selon l'une quelconque des revendications précédentes, **caractérisé en ce que** l'on utilise un codage géographique selon le procédé de transformation Fourier à deux dimensions ou plus.

9.  Procédé selon l'une quelconque des revendications 1 à 7, **caractérisé en ce que** l'on utilise un codage géographique selon le procédé de la rétroprojection filtrée.

**Fig.1**

**Fig.2**

**Fig.3**

**Fig.4**

**Fig.5**

**Fig.6**

**Fig.7**